# EUROPEAN PATENT APPLICATION

(11) **EP 4 683 479 A1**
(43) Date of publication of application: **21.01.2026**
(21) Application number: 25189805.2
(22) Date of filing: 16.07.2025
(51) Int. Cl.: H10K 59/80

(54) **DISPLAY DEVICE AND ELECTRONIC DEVICE INCLUDING MULTI-LAYER ELECTRODES**

(30) Priority: 17.07.2024 KR 20240094690; 01.11.2024 KR 20240153490
(71) Applicant: Samsung Display Co., Ltd., Yongin-si, Gyeonggi-do 17113 (KR)
(72) Inventor: NOH, Hyunwoo, 17113 Yongin-si (KR); KIM, Youngmin, 17113 Yongin-si (KR); BAEK, Moonjung, 17113 Yongin-si (KR)
(74) Representative: Taor, Simon Edward William

(57) **Abstract**

A display device includes a base layer including first to third light emitting regions, a lower electrode including first to third reflective electrodes and first to third transparent electrodes, an organic layer disposed on the lower electrode and including an emission layer, an upper electrode disposed on the organic layer, and a separation layer disposed between the first reflective electrode and the first transparent electrode and between the second reflective electrode and the second transparent electrode. First and second contact holes are defined in the separation layer overlapping the first light emitting region and the second light emitting region, respectively. The first transparent electrode is disposed in the first contact hole and is connected to the first reflective electrode. The second transparent electrode is disposed in the second contact hole and is connected to the second reflective electrode.

## Description

### CROSS-REFERENCE TO RELATED APPLICATIONS

This U.S. non-provisional patent application claims priority to Korean Patent Application No. 10-2024-0094690, filed on July 17, 2024, and Korean Patent Application No. 10-2024-0153490, filed on November 1, 2024.

### TECHNICAL FIELD

The present disclosure relates to an electronic device and, more particularly, to a display device and an electronic device including multi-layered electrodes.

### DISCUSSION OF THE RELATED ART

Display devices such as televisions, computer monitors, smartphones, and tablet computers that provide users with images include display panels for displaying images. Display panels may be made of various different types, such as liquid crystal display (LCD) panels, organic light emitting diode (OLED) display panels, electrowetting display panels, and electrophoretic display panels.

To enhance the reliability of display panels, research has been directed towards patterning approaches for light emitting elements, and studies have explored high-resolution electronic devices including luminescent materials commonly provided through an open mask.

### SUMMARY

An electronic device includes a base layer including first to third light emitting regions and a non-light emitting region. A lower electrode includes first to third reflective electrodes overlapping the first to third light emitting regions respectively. First to third transparent electrodes are disposed on the first to third reflective electrodes. An organic layer is disposed on the lower electrode and includes an emission layer. An upper electrode is disposed on the organic layer. A separation layer is disposed between the first reflective electrode and the first transparent electrode and between the second reflective electrode and the second transparent electrode. First and second contact holes are defined in the separation layer overlapping the first light emitting region and the second light emitting region, respectively. The first transparent electrode is disposed in the first contact hole and is connected to the first reflective electrode. The second transparent electrode is disposed in the second contact hole and is connected to the second reflective electrode.

The separation layer may include a first inorganic layer and a second inorganic layer each containing an inorganic material.

The first inorganic layer and the second inorganic layer may be disposed between the first reflective electrode and the first transparent electrode, and the first inorganic layer may be disposed alone between the second reflective electrode and the second transparent electrode.

A first distance from the first reflective electrode to the first transparent electrode may be greater than a second distance from the second reflective electrode to the second transparent electrode.

The first inorganic layer and the second inorganic layer may each contain at least one of silicon oxide (SiOₓ), silicon nitride (SiNₓ), and silicon oxynitride (SiOₓN_{y}).

The electronic device may further include a first pattern disposed on the first transparent electrode overlapping the first contact hole and a second pattern disposed on the second transparent electrode overlapping the second contact hole.

The electronic device may further include a pixel defining film disposed on the base layer and having pixel openings, exposing at least a portion of each of the first to third transparent electrodes, defined therein.

The first pattern and the second pattern may include a same material as the pixel defining film.

The pixel defining film, the first pattern, and the second pattern may include either an organic material or an inorganic material.

An upper surface of the first pattern may be coplanar with an upper surface of the first transparent electrode, which does not overlap the first contact hole, and an upper surface of the second pattern may be coplanar with an upper surface of the second transparent electrode, which does not overlap the second contact hole.

The first pattern and the second pattern each may include a first portion disposed inside a corresponding contact hole and a second portion disposed on the first portion and protruding from a corresponding transparent electrode.

A side surface of the separation layer defining the first contact hole may be inclined at a first predetermined angle from the first reflective electrode, and a side surface of the separation layer defining the second contact hole may be inclined at a second predetermined angle from the second reflective electrode.

The third reflective electrode and the third transparent electrode may be in direct contact with one another.

The first to third reflective electrodes may each include a first layer including a transparent conductive oxide, a second layer disposed on the first layer and including a reflective metal material, and a third layer disposed on the second layer and including a transparent conductive oxide.

The electronic device may further include an encapsulation layer disposed on the upper electrode and a color filter layer disposed on the encapsulation layer and including first to third color filters overlapping the first to third light emitting regions, respectively.

The electronic device may further include an overcoat layer disposed on the color filter layer.

The first to third light emitting regions may be different in planar shape and area from one another.

The first and second light emitting regions may be different from the first and second contact holes in planar shape.

The first light emitting region may have a same planar shape as the first contact hole, and the second light emitting region may have a same planar shape as the second contact hole.

The first to third reflective electrodes may each be spaced apart from one another and disposed in a same layer.

A display device includes a base layer including a first light emitting region, a second light emitting region, a third light emitting region, and a non-light emitting region. A lower electrode includes a first reflective electrode overlapping the first light emitting region, a second reflective electrode overlapping the second light emitting region, a third reflective electrode overlapping the third light emitting region, a first transparent electrode disposed on the first reflective electrode, a second transparent electrode disposed on the second reflective electrode, and a third transparent electrode disposed on the third reflective electrode. An organic layer is disposed on the lower electrode and including an emission layer. An upper electrode is disposed on the organic layer. A separation layer is disposed between the first reflective electrode and the first transparent electrode and between the second reflective electrode and the second transparent electrode.

A first contact hole may be defined in the separation layer overlapping the first light emitting region and a second contact hole may be defined in the separation layer overlapping the second light emitting region.

The first transparent electrode may be disposed in the first contact hole and connected to the first reflective electrode, and the second transparent electrode may be disposed in the second contact hole and connected to the second reflective electrode.

### BRIEF DESCRIPTION OF THE FIGURES

The accompanying drawings are included to provide a further understanding of the present inventive concept, and are incorporated in and constitute a part of this specification. The drawings illustrate embodiments of the present inventive concept and, together with the description, serve to explain principles of the present inventive concept. In the drawings:
FIG. 1 is a perspective view illustrating an electronic device according to an embodiment of the present inventive concept;
FIG. 2A is a perspective view illustrating an electronic device according to an embodiment of the present inventive concept;
FIG. 2B is an exploded perspective view illustrating an electronic device according to an embodiment of the present inventive concept;
FIGS. 3A, 3B, and 3C are plan views illustrating a display panel according to an embodiment of the present inventive concept;
FIG. 4 is a cross-sectional view taken along line I-I' of FIG. 3A;
FIG. 5 is a cross-sectional view illustrating a display panel according to an embodiment of the present inventive concept;
FIG. 6 is a cross-sectional view illustrating a display panel according to an embodiment of the present inventive concept;
FIG. 7 is a plan view illustrating a display panel according to an embodiment of the present inventive concept;
FIG. 8 is a plan view illustrating a display panel according to an embodiment of the present inventive concept; and
FIG. 9 is a cross-sectional view illustrating a light emitting element according to an embodiment of the present inventive concept.

### DETAILED DESCRIPTION

In this specification, it will be understood that when an element (or a region, a layer, a portion, or the like) is referred to as being "on", "connected to" or "coupled to" another element, it may be directly disposed on, connected to, or coupled to the other element, or other elements may be disposed therebetween.

Like reference numerals or symbols may refer to like elements throughout the specification and the drawings. In the drawings, while each drawing may represent one or more particular embodiments of the present disclosure, drawn to scale, such that the relative lengths, thicknesses, and angles can be inferred therefrom, it is to be understood that the present invention is not necessarily limited to the relative lengths, thicknesses, and angles shown. Changes to these values may be made within the scope of the present disclosure, for example, to allow for manufacturing limitations and the like. As used herein, the term "and/or" includes any and all combinations of one or more of the associated listed elements.

It will be understood that, although the terms "first", "second", etc. may be used herein to describe various elements, the elements are not to be limited by these terms. These terms are used to distinguish one element from another element. For instance, a first element could be termed a second element without departing from the scope of the present inventive concept. Similarly, a second element could be termed a first element. The singular expressions "a", "an" and "the" are intended to include the plural forms as well, unless the context clearly indicates otherwise.

In addition, the terms "below", "under", "on the lower side", "above", "over", "on the upper side", or the like may be used to describe the relationships between the elements illustrated in the drawings. These terms are relative concepts and are described on the basis of the directions indicated in the drawings.

It will be further understood that the terms "comprises, includes, has" and/or "comprising, including, having", when used in this specification, specify the presence of stated features, numbers, steps, operations, elements, components or combinations thereof, but do not preclude the possibility of the presence or addition of one or more other features, numbers, steps, operations, elements, components, and/or combinations thereof.

Embodiments of the present disclosure relate to a high-resolution display panel that utilizes a layered electrode and separation structure to optimize light emission and efficiency. The multi-layered electrode may include reflective and transparent electrodes at each light-emitting region. A separator composed of inorganic materials like silicon oxide, silicon nitride, or silicon oxynitride may be disposed between the reflective and transparent electrodes to improve optical resonance and efficiency. This combination of reflective and transparent electrodes may be customized for each of the three distinct colored light-emitting regions, including red, green, and blue, and the separation layer may be tailored to control the spacing between reflective and transparent electrodes, which allows for the optimization of resonance frequencies for each of the different colors.

Dedicated contact holes may be used to connect the reflective and transparent electrodes so as to improve electrical efficiency without increasing the non-light emitting area. Thus, better current flow may be achieved while maintaining high aperture ratios.

A special pixel defining film may also be used to help control the light-emitting regions and prevent unwanted light leakage so as to enhance color accuracy and pixel precision.

Hereinafter, embodiments of the present invention are described with reference to the drawings.

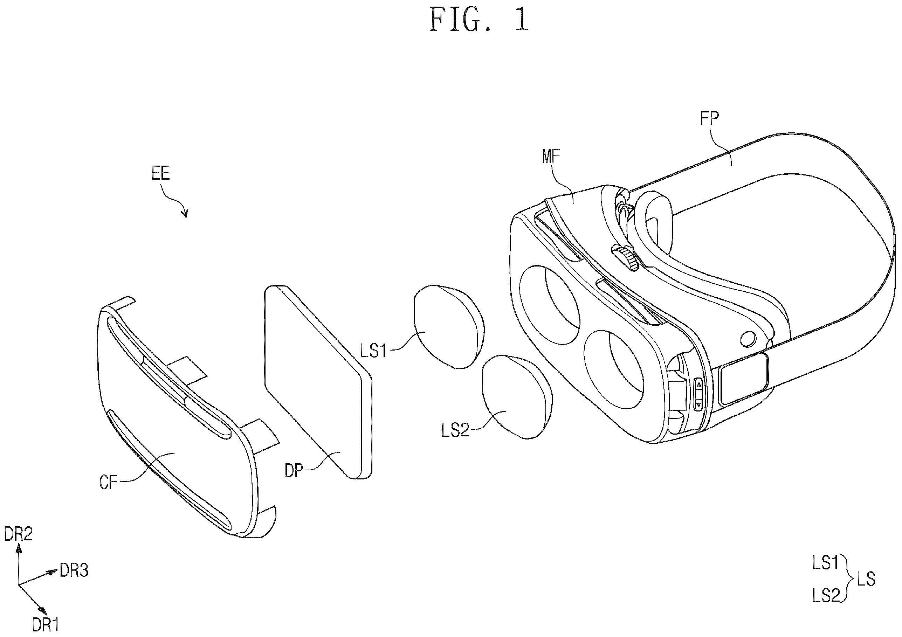

FIG. 1 is a perspective view illustrating an electronic device EE according to an embodiment of the present inventive concept. The electronic device EE may be an electronic device activated in response to electrical signals. For example, the electronic device EE may be televisions, computer monitors, outdoor digital billboards, portable game consoles, laptop/notebook computers, mobile phones, tablet computers, navigation systems, and wearable devices, but embodiments of the present inventive concept are not necessarily limited thereto.

FIG. 1 shows a head mounted display HMD device as an example of the electronic device EE. The head mounted display device may be a device mounted on a user's head to provide the user with a screen on which an image or video is displayed. The head mounted display device may include a see-through type device that provides augmented reality (AR) based on real external objects and opaque type device that provides users with virtual reality (VR) on a screen without the ability to directly view the environment.

Referring to FIG. 1, the electronic device EE may include a display panel DP and a lens portion LS facing the display panel DP. In addition, the electronic device EE may include a main frame MF, a cover frame CF, and a fixing portion FP.

The main frame MF may be a portion worn on the user's face. The main frame MF may have a shape corresponding to the shape of the user's head (e.g., face). For example, the length of the fixing portion FP may be adjusted according to the circumference of the user's head. The fixing portion FP is a structure that allows the main frame MF to be readily mounted on the head, and may include a strap, a belt, or the like. However, embodiments of the present inventive concept are not necessarily limited thereto, and the fixing portion FP may have various shapes such as a helmet or an eyeglass temple coupled with the main frame MF.

The lens portion LS, the display panel DP, and the cover frame CF may be mounted on the main frame MF. The main frame MF may include a space or structure in which the lens portion LS and the display panel DP may be accommodated.

The lens portion LS may be disposed between the display panel DP and the user. The lens portion LS may allow light emitted from the display panel DP to pass therethrough and may provide the light to the user. For example, the lens portion LS may include various types of lenses such as a multi-channel lens, a convex lens, a concave lens, a spherical lens, an aspheric lens, a single lens, a compound lens, a standard lens, a narrow-angle lens, a wide-angle lens, a fixed focus lens, and a variable focus lens.

The lens portion LS may include a first lens LS1 and a second lens LS2. The first lens LS1 and the second lens LS2 may be disposed to correspond to positions of the user's left and right eyes, respectively. The first lens LS1 and the second lens LS2 may be accommodated inside the main frame MF.

The display panel DP may be provided in a state of being fixed to the main frame MF or may be provided in a detachable manner. The display panel DP will be described in more detail below.

The cover frame CF may be disposed on a surface of the display panel DP to protect the display panel DP. The cover frame CF and the lens portion LS may be spaced apart from each other with the display panel DP interposed therebetween.

In FIG. 1 and the following drawings, a first direction DR1 to a third direction DR3 are illustrated. The directions indicated by the first to third directions DR1, DR2, and DR3 illustrated in this specification may be used for convenience and thus may be changed to other directions. The directions indicated by the first to third directions DR1, DR2, and DR3 may be described as the first to third directions, and may thus be denoted as the same reference numerals or symbols. In this specification, the first direction DR1 and the second direction DR2 may be perpendicular to each other, and the third direction DR3 may be a direction normal to the plane defined by the first direction DR1 and the second direction DR2.

A thickness direction of the electronic device EE may be parallel to the third direction DR3 that is a direction normal to the plane defined by the first direction DR1 and the second direction DR2. In this specification, a front surface (or upper surface) and a rear surface (or lower surface) of each member forming the electronic device EE may be defined with respect to the third direction DR3. In this specification, "on a plane" or "in a plan view" means a plane parallel to the plane defined by the first and second directions DR1 and DR2, and "on a cross section" or "in a cross-sectional view" means a plane parallel to the third direction DR3. A "planar shape" is defined herein as the shape of an object on a plane/in a plan view.

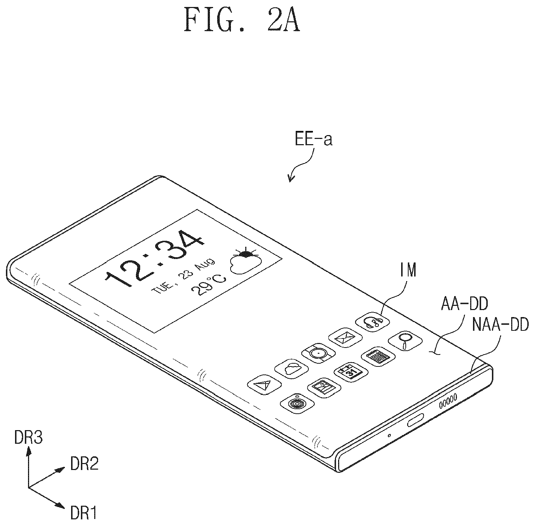

FIG. 2A is a perspective view illustrating an electronic device EE-a according to an embodiment of the present inventive concept. FIG. 2A is a perspective view illustrating another embodiment of the electronic device an embodiment of the present inventive concept, illustrating a mobile phone as an example an electronic device EE-a.

The electronic device EE-a may display an image IM through an active region AA-DD. The active region AA-DD may include a flat surface defined by a first direction DR1 and a second direction DR2. The active region AA-DD may further include a curved surface that bends from at least one side of the flat surface defined by the first direction DR1 and the second direction DR2. However, this is merely an example, and the shape of the active region AA-DD is not necessarily limited thereto. For example, the active region AA-DD may include the flat surface, or the active region AA-DD may further include four curved surfaces that each bend from at least two sides, for example, four sides of the flat surface.

A peripheral region NAA-DD may be adjacent to the active region AA-DD. The peripheral region NAA-DD may surround the active region AA-DD on at least two sides thereof or be proximate to one side thereof. Accordingly, the shape of the active region AA-DD may be substantially defined by the peripheral region NAA-DD. However, this is illustrated as an example, and the peripheral region NAA-DD may be disposed adjacent to only a side of the active region AA-DD or might not be provided. The active region AA-DD may be provided in various shapes and embodiments are not limited thereto.

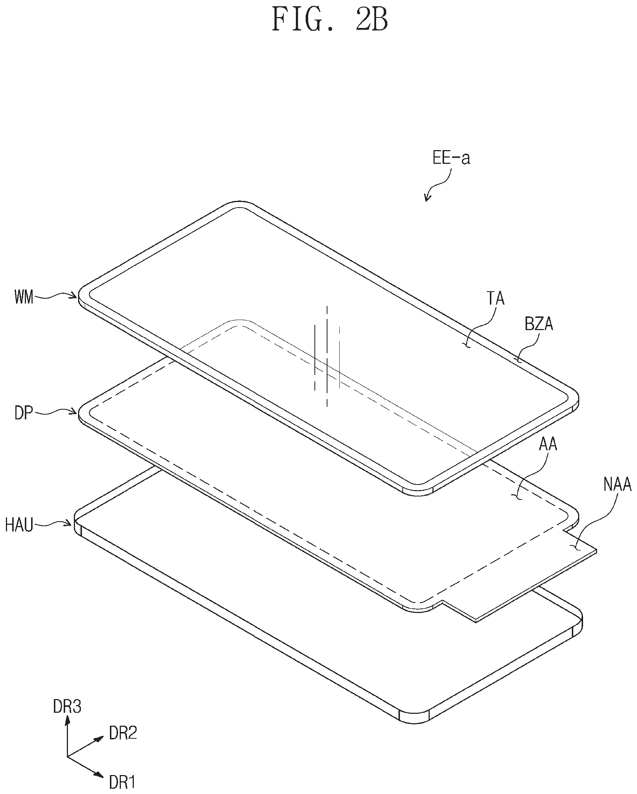

FIG. 2B is an exploded perspective view of the electronic device EE-a shown in FIG. 2A. Referring to FIG. 2B, the electronic device EE-a may include a housing HAU, a display panel DP, and a window WM.

The window WM may cover an entire outer portion of the display panel DP. The window WM may include a transmission region TA and a bezel region BZA. A front surface of the window WM including the transmission region TA and the bezel region BZA may serve as a front surface of the electronic device EE-a. The transmission region TA may correspond to the active region AA-DD of the electronic device EE-a shown in FIG. 2A, and the bezel region BZA may correspond to the peripheral region NAA-DD of the electronic device EE-a shown in FIG. 2A.

The transmission region TA may be an optically transparent region. The bezel region BZA may be a region having a relatively lower light transmittance than the transmission region TA. The bezel region BZA may have a predetermined color. The bezel region BZA may be adjacent to the transmission region TA and may surround the transmission region TA. The bezel region BZA may define a shape of the transmission region TA. However, embodiments of the present inventive concept are not necessarily limited to what is shown, and the bezel region BA may be disposed adjacent to only one side of the transmission region TA, and a portion thereof might not be provided.

The display panel DP may include an active region AA and a peripheral region NAA. The active region AA may correspond to the active region AA-DD of the electronic device EE-a shown in FIG. 2A, and the peripheral region NAA may correspond to the peripheral region NAA-DD of the electronic device EE-a shown in FIG. 2A. Pixels for generating images may be disposed in the active region AA. Driving elements and signal lines for driving the pixels disposed in the active region AA may be disposed in the peripheral region NAA. One region of the peripheral region NAA may be bent with respect to a bending axis extending along the second direction DR2 and may overlap the active region AA.

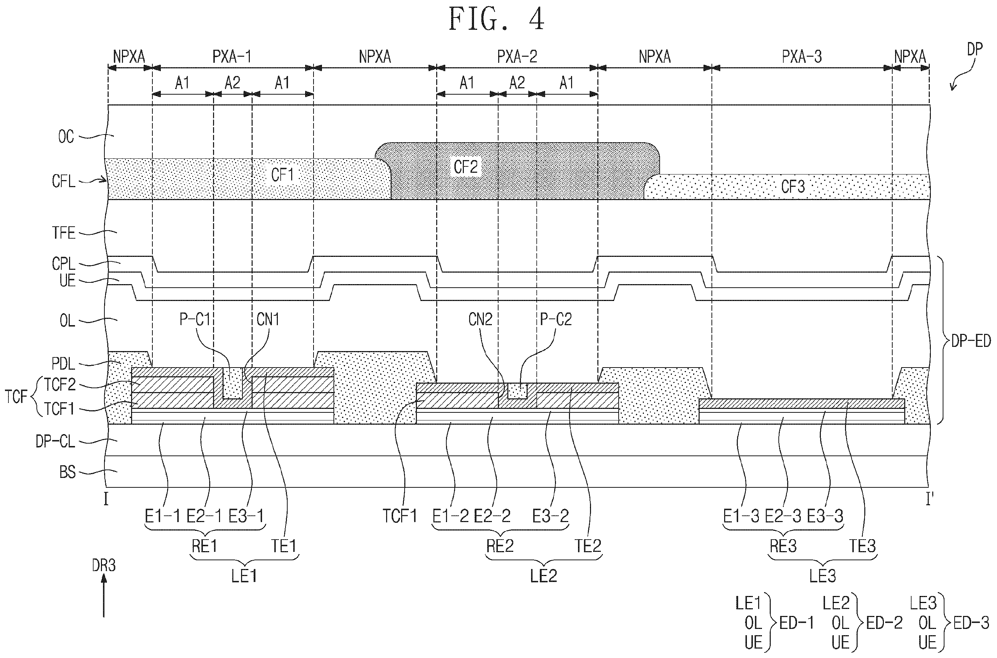

An input sensing portion may be provided on the display panel DP. The input sensing portion may sense external inputs applied from the outside. The external inputs may be user inputs. The user inputs may include various types of external inputs such as a body part of users, light, heat, pen/stylus, or pressure. More specifically, the input sensing portion may be disposed on an encapsulation layer TFE (see FIG. 4) of the display panel DP, which will be described below. Alternatively, the input sensing portion may be disposed directly on the encapsulation layer TFE (see FIG. 4) or may be disposed directly on an adhesive disposed on the encapsulation layer TFE (see FIG. 4). The adhesive may include a typical adhesive or bonding agent.

In this specification, it will be understood that when a component (or a region, a layer, a portion, or the like) is referred to as being "directly on" another component, no third component is disposed between the component and the other component. For example, when a component is "directly disposed" on another component, it indicates that the component is in "direct contact" with the other component.

The housing HAU may accommodate the display panel DP and the like. The housing HAU may be coupled to the window WM.

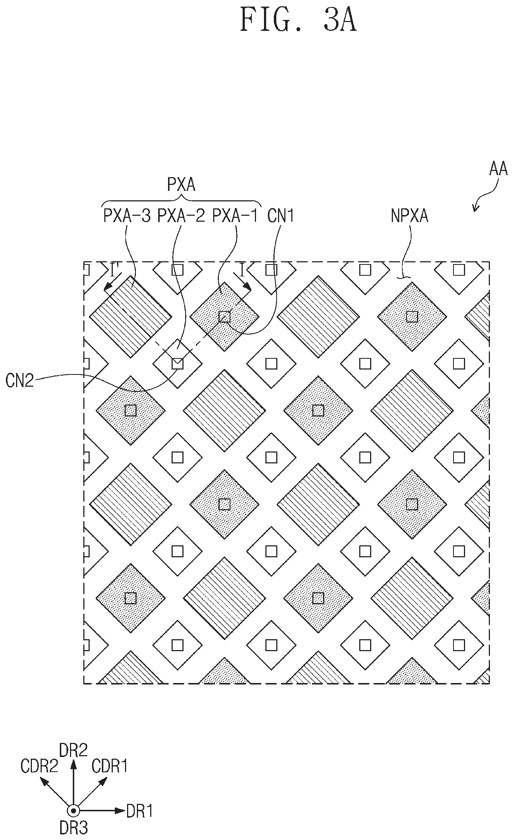

FIGS. 3A-3C are plan views of a display panel DP according to an embodiment. Hereinafter, the description of the display panel DP may equally apply to the display panel DP included in the electronic devices EE and EE-a shown in FIGS. 1 and 2B.

Referring to FIGS. 3A-3C, the display panel DP may include a light emitting region PXA and a non-light emitting region NPXA. The non-light emitting region NPXA may surround the light emitting region PXA. The light emitting region PXA may be provided in plural. The light emitting regions PXA may each include a first light emitting region PXA-1, a second light emitting region PXA-2, and a third light emitting region PXA-3. Each of the first light emitting region PXA-1, the second light emitting region PXA-2, and the third light emitting region PXA-3 may emit light having a different wavelength range.

The first light emitting region PXA-1 may emit first light, and the second light emitting region PXA-2 may emit second light different from the first light. The third light emitting region PXA-3 may emit third light different from the first and second light. The first light may be red light, the second light may be green light, and the third light may be blue light.

For example, any one first light emitting region PXA-1 and any one third light emitting region PXA-3 may be spaced apart from one another along the first direction DR1. The any one first light emitting region PXA-1 and any one second light emitting region PXA-2 may be spaced apart from one another along a first diagonal direction CDR1, and the third light emitting region PXA-3 and the second light emitting region PXA-2 may be spaced apart from one another along a second diagonal direction CDR2.

The first light emitting region PXA-1 and the third light emitting region PXA-3 spaced apart from one another along the first direction DR1 and the two second light emitting regions PXA-2 adjacent along the first direction DR1 and spaced apart from one another along the diagonal directions CDR1 and CDR2 from the first light emitting region PXA-1 and the third light emitting region PXA-3 may be defined as one sub-pixel.

According to an embodiment of the present inventive concept, each of the first to third light emitting regions PXA-1, PXA-2, and PXA-3 may have a rhombus shape. Among the first to third light emitting regions PXA-1, PXA-2, and PXA-3, the third light emitting region PXA-3 may have a largest area, and the second light emitting region PXA-2 may have a smallest area. However, this is merely an example, and the areas of the first to third light emitting regions PXA-1, PXA-2, and PXA-3 are not necessarily limited thereto.

In FIG. 3A, the first light emitting region PXA-1 and the third light emitting region PXA-3 may be alternately disposed in a row, and the second light emitting region PXA-2 may be spaced apart from the first light emitting region PXA-1 and the third light emitting region PXA-3, and may be disposed in a different row. However, this is merely an example, and the arrangement of the first to third light emitting regions PXA-1, PXA-2 and PXA-3 is not necessarily limited thereto.

According to an embodiment of the present inventive concept, among the first to third light emitting regions PXA-1, PXA-2, and PXA-3, contact holes CN1 and CN2 may be defined in the first and second light emitting regions PXA-1 and PXA-2. For example, the first contact hole CN1 may be defined in the first light emitting region PXA-1, and the second contact hole CN2 may be defined in the second light emitting region PXA-2.

The first contact hole CN1 may be defined in the first light emitting region PXA-1. The second contact hole CN2 may be defined in the second light emitting region PXA-2. According to an embodiment of the present inventive concept, the contact holes CN1 and CN2 may be spaced apart from (might not overlap) the third light emitting region PXA-3. Descriptions thereof will be provided later.

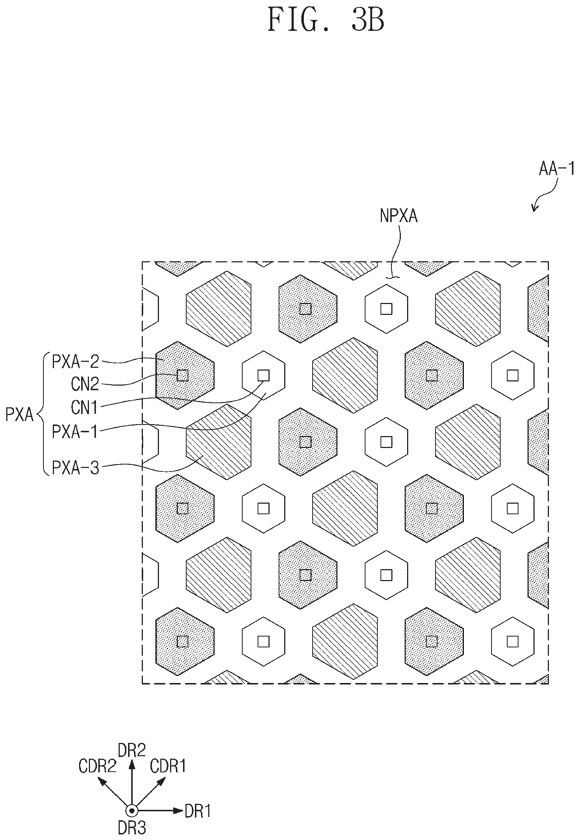

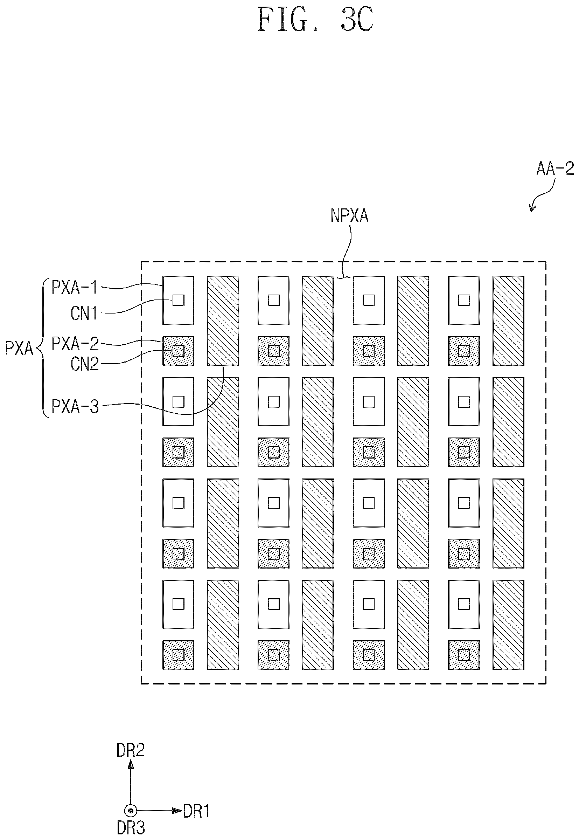

FIGS. 3B and 3C are plan views illustrating a display panel DP according to an embodiment. Hereinafter, the description of the display panel DP may equally apply to the display panel DP included in the electronic devices EE and EE-a shown in FIGS. 1 and 2B and to the extent that an element is not described in detail with respect to this figure, it may be understood that the element is at least similar to a corresponding element that has been described elsewhere within the present disclosure.

Referring to FIG. 3B, an active region AA-1 of the display panel DP may include a light emitting region PXA and a non-light emitting region NPXA. The non-light emitting region NPXA may surround the light emitting region PXA. The light emitting region PXA may be provided in plural. The light emitting regions PXA may each include a first light emitting region PXA-1, a second light emitting region PXA-2, and a third light emitting region PXA-3. Each of the first light emitting region PXA-1, the second light emitting region PXA-2, and the third light emitting region PXA-3 may emit light having a different wavelength range.

The first light emitting region PXA-1 may emit first light, and the second light emitting region PXA-2 may emit second light different from the first light. The third light emitting region PXA-3 may emit third light different from the first and second light. The first light may be red light, the second light may be green light, and the third light may be blue light.

For example, any one first light emitting region PXA-1 and any one third light emitting region PXA-3 may be spaced apart from one another along the first diagonal direction CDR1. The any one first light emitting region PXA-1 and any one second light emitting region PXA-2 may be spaced apart from one another along the first direction DR1, and the third light emitting region PXA-3 and the second light emitting region PXA-2 may be spaced apart from one another along the second diagonal direction CDR2. The first to third light emitting regions PXA-1, PXA-2, and PXA-3 adjacent to each other may be defined as one sub-pixel.

According to an embodiment of the present inventive concept, each of the first to third light emitting regions PXA-1, PXA-2, and PXA-3 may have different shapes. For example, the first light emitting region PXA-1 may have a hexagonal. Each of the second and third light emitting regions PXA-2 and PXA-3 may have a hexagonal shape.

According to an embodiment of the present inventive concept, the first light emitting region PXA-1 may define a hexagonal shape with eight sides combined. The eight sides may alternately face each of the short sides of the second light emitting region PXA-2 and the third light emitting region PXA-3.

According to an embodiment of the present inventive concept, each of the second and third light emitting regions PXA-2 and PXA-3 may define a hexagonal shape with three long sides and three short sides combined. A first long side of the second light emitting region PXA-2 may face any one long side of the third light emitting region PXA-3 along the first diagonal direction CDR1. A second long side of the second light emitting region PXA-2 may face any one long side of other third light emitting region PXA-3 along the second diagonal direction CDR2. A third long side of the second light emitting region PXA-2 may face any one long side of another third light emitting region PXA-3 along the second direction DR2.

Among the first to third light emitting regions PXA-1, PXA-2, and PXA-3, the third light emitting region PXA-3 may have a largest area, and the first light emitting region PXA-1 may have a smallest area. However, this is merely an example, and the areas of the first to third light emitting regions PXA-1, PXA-2, and PXA-3 are not necessarily limited thereto.

According to an embodiment of the present inventive concept, among the first to third light emitting regions PXA-1, PXA-2, and PXA-3, contact holes CN1 and CN2 may be defined in the first and second light emitting regions PXA-1 and PXA-2. For example, the first contact hole CN1 may be defined in the first light emitting region PXA-1, and the second contact hole CN2 may be defined in the second light emitting region PXA-2.

The first contact hole CN1 may be defined in the first light emitting region PXA-1. The second contact hole CN2 may be defined in the second light emitting region PXA-2. According to an embodiment of the present inventive concept, the contact holes CN1 and CN2 may be spaced apart from (might not overlap) the third light emitting region PXA-3. Descriptions thereof will be provided later.

Referring to FIG. 3C, an active region AA-2 of the display panel DP may include a light emitting region PXA and a non-light emitting region NPXA. The non-light emitting region NPXA may surround the light emitting region PXA. The light emitting region PXA may be provided in plural. The light emitting regions PXA may each include a first light emitting region PXA-1, a second light emitting region PXA-2, and a third light emitting region PXA-3. Each of the first light emitting region PXA-1, the second light emitting region PXA-2, and the third light emitting region PXA-3 may emit light having a different wavelength range.

The first light emitting region PXA-1 may emit first light, and the second light emitting region PXA-2 may emit second light different from the first light. The third light emitting region PXA-3 may emit third light different from the first and second light. The first light may be red light, the second light may be green light, and the third light may be blue light.

According to an embodiment of the present inventive concept, the first to third light emitting regions PXA-1, PXA-2, and PXA-3 may have a rectangle shape. For example, the third light emitting region PXA-3 may have a rectangular shape extending along the second direction DR2. When viewed from the first direction DR1, the first light emitting region PXA-1 and the second light emitting region PXA-2 may overlap the third light emitting region PXA-3. The first to third light emitting regions PXA-1, PXA-2, and PXA-3 adjacent to each other may be defined as one sub-pixel.

Among the first to third light emitting regions PXA-1, PXA-2, and PXA-3, the third light emitting region PXA-3 may have a largest area, and the second light emitting region PXA-2 may have a smallest area. However, this is merely an example, and the areas of the first to third light emitting regions PXA-1, PXA-2, and PXA-3 are not necessarily limited thereto.

According to an embodiment of the present inventive concept, among the first to third light emitting regions PXA-1, PXA-2, and PXA-3, contact holes CN1 and CN2 may be defined in the first and second light emitting regions PXA-1 and PXA-2. For example, the first contact hole CN1 may be defined in the first light emitting region PXA-1, and the second contact hole CN2 may be defined in the second light emitting region PXA-2.

The first contact hole CN1 may be defined in the first light emitting region PXA-1. The second contact hole CN2 may be defined in the second light emitting region PXA-2. According to an embodiment of the present inventive concept, the contact holes CN1 and CN2 may be spaced apart from (might not overlap) the third light emitting region PXA-3. Descriptions thereof will be provided later.

The display panel DP may include a base layer BS, a circuit layer DP-CL disposed on the base layer BS, a display element layer DP-ED disposed on the circuit layer DP-CL, and an encapsulation layer TFE disposed on the display element layer DP-ED. In addition, the display panel DP may further include a color filter layer CFL disposed on the encapsulation layer TFE.

The base layer BS may provide a base surface on which the circuit layer DP-CL is disposed. The base layer BS may be a rigid substrate, or a flexible substrate that is bendable, foldable, rollable, to at least a noticeable extent without cracking or otherwise sustaining damage, or the like. The base layer BS may be a glass substrate, a metal substrate, or a polymer substrate. However, embodiments of the present inventive concept are not necessarily limited thereto, and the base layer BS may be an inorganic layer, an organic layer, or a composite material layer.

The base layer BS may include a single- or multi-layered structure. For example, the base layer BS may include a first synthetic resin layer, a multi-layered or singlelayered intermediate layer, and a second synthetic resin layer, which are sequentially stacked. The intermediate layer may be referred to as a base barrier layer. The intermediate layer may include a silicon oxide (SiOₓ) layer and an amorphous silicon (a-Si) layer disposed on the silicon oxide layer, but is not necessarily particularly limited thereto. For example, the intermediate layer may include at least one of a silicon oxide layer, a silicon nitride layer, a silicon oxynitride layer, or an amorphous silicon layer.

The first and second synthetic resin layers may each include a polyimidebased resin. In addition, the first and second synthetic resin layers may each include at least one among an acrylic-based resin, a methacrylate-based resin, a polyisoprene-based resin, a vinyl-based resin, an epoxy-based resin, a urethane-based resin, a cellulose-based resin, a siloxane-based resin, a polyamide-based resin, and a perylene-based resin.

The circuit layer DP-CL may be disposed on the base layer BS. The circuit layer DP-CL may include an insulating layer, a semiconductor pattern, a conductive pattern, a signal line, and the like. The insulating layer, the semiconductor layer, and the conductive layer may be formed on the base layer BS through methods such as coating or vapor deposition, and then selectively patterned through multiple times of a photolithography process. Thereafter, the semiconductor pattern, the conductive pattern, and the signal line included in the circuit layer DP-CL may be formed.

In an embodiment, the base layer BS may be a silicon substrate. The base layer BS may be a monocrystalline silicon wafer, a polycrystalline silicon wafer, or an amorphous silicon wafer. The circuit layer DP-CL may include an insulating layer, a semiconductor pattern, a conductive pattern, a signal line, and the like, which are formed on a silicon wafer.

The display element layer DP-ED may be disposed on the circuit layer DP-CL. The display element layer DP-ED may include first to third light emitting elements ED-1, ED-2, and ED-3, a separation layer TCF, a pixel defining film PDL, and a capping layer CPL.

The first to third light emitting elements ED-1, ED-2, and ED-3 may be spaced apart in a direction crossing the third direction DR3, which is a thickness direction. Each of the first to third light emitting elements ED-1, ED-2, and ED-3 may include lower electrodes LE1, LE2, and LE3, an organic layer OL disposed on the lower electrodes LE1, LE2, and LE3, and an upper electrode UE disposed on the organic layer OL. In addition, the display element layer DP-ED may include the capping layer CPL disposed on the upper electrode UE.

The lower electrodes LE1, LE2, and LE3 may include reflective electrodes RE1, RE2, and RE3 disposed on the circuit layer DP-CL and transparent electrodes TE1, TE2, and TE3 disposed on the reflective electrodes RE1, RE2, and RE3. In this specification, the lower electrodes LE1, LE2, and LE3 may indicate "anode". The lower electrodes LE1, LE2, and LE3 may include a structure in which the reflective electrodes RE1, RE2, and RE3 and the transparent electrodes TE1, TE2, and TE3 are stacked.

The reflective electrodes RE1, RE2, and RE3 may include a first reflective electrode RE1 included in the first light emitting element ED-1, a second reflective electrode RE2 included in the second light emitting element ED-2, and a third reflective electrode RE3 included in the third light emitting element ED-3.

Each of the first reflective electrode RE1, the second reflective electrode RE2, and the third reflective electrode RE3 may include one electrode having a three-layer structure. Each of the first reflective electrode RE1, the second reflective electrode RE2, and the third reflective electrode RE3 may include first layers E1-1, E1-2, and E1-3, second layers E2-1, E2-2, and E2-3, and third layers E3-1, E3-2, and E3-3, which are sequentially stacked.

Each of the first layers E1-1, E1-2, and E1-3 and the third layers E3-1, E3-2, and E3-3 may include a transparent conductive oxide. Each of the first layers E1-1, E1-2, and E1-3 and the third layers E3-1, E3-2, and E3-3 may include at least one of indium tin oxide (ITO), indium zinc oxide (IZO), indium gallium zinc oxide (IGZO), zinc oxide (ZnOₓ) or indium oxide (In₂O₃), and aluminum-doped zinc oxide (AZO). For example, each of the first layers E1-1, E1-2, and E1-3 and the third layers E3-1, E3-2, and E3-3 may include indium tin oxide (ITO) or indium zinc oxide (IZO).

The second layers E2-1, E2-2, and E2-3 may include a reflective metal material. The second layers E2-1, E2-2, and E2-3 may include a metal with high reflectivity, an oxide of a metal with high reflectivity, or a nitride of a metal with high reflectivity. The second layers E2-1, E2-2, and E2-3 may include any one among Ag, Mg, Cu, Al, Pt, Pd, Au, Ni, Nd, Ir, Cr, Li, Ca, LiF/Ca, LiF/Al, Mo, and Ti, which exhibit high reflectivity. For example, the second layers E2-1, E2-2, and E2-3 may include Ag.

The transparent electrodes TE1, TE2, and TE3 may include a first transparent electrode TE1 included in the first light emitting element ED-1, a second transparent electrode TE2 included in the second light emitting element ED-2, and a third transparent electrode TE3 included in the third light emitting element ED-3.

Each of the first transparent electrode TE1, the second transparent electrode TE2, and the third transparent electrode TE3 may include a transparent conductive oxide. Each of the first transparent electrode TE1, the second transparent electrode TE2, and the third transparent electrode TE3 may include at least one of indium tin oxide (ITO), indium zinc oxide (IZO), indium gallium zinc oxide (IGZO), zinc oxide (ZnOₓ) or indium oxide (In₂O₃), and aluminum doped zinc oxide (AZO). For example, each of the first transparent electrode TE1, the second transparent electrode TE2, and the third transparent electrode TE3 may include indium tin oxide (ITO) or indium zinc oxide (IZO).

The separation layer TCF is disposed between at least some of the reflective electrodes RE1, RE2, and RE3 and the transparent electrodes TE1, TE2, and TE3. The separation layer TCF may be disposed between at least some of the reflective electrodes RE1, RE2, and RE3 and the transparent electrodes TE1, TE2, and TE3 to adjust the resonance distance of each of the first to third light emitting elements ED-1, ED-2, and ED-3. The separation layer TCF may be disposed between at least some of the reflective electrodes RE1, RE2, and RE3 and the transparent electrodes TE1, TE2, and TE3, and thus the reflective electrodes RE1, RE2, and RE3 and the transparent electrodes TE1, TE2, and TE3 may be spaced apart from each other, and accordingly, light emitted from each of the first to third light emitting elements ED-1, ED-2, and ED-3 may be designed to create an optimal resonance frequency that induces optical resonance at a specific wavelength.

According to an embodiment, the lower electrodes LE1, LE2, and LE3 may include only the reflective electrodes RE1, RE2, and RE3 and might not include the transparent electrodes TE1, TE2, and TE3. The lower electrodes LE1, LE2, and LE3 may include the reflective electrodes RE1, RE2, and RE3, and the reflective electrodes RE1, RE2, and RE3 may include, for example, titanium nitride (TiN). At least a portion of the separation layer TCF may be disposed on the reflective electrodes RE1, RE2, and RE3.

The separation layer TCF may include a first inorganic film TCF1 and a second inorganic film TCF2. The first inorganic film TCF1 is disposed between the first reflective electrode RE1 and the first transparent electrode TE1. The first inorganic film TCF 1 may be disposed between the second reflective electrode RE2 and the second transparent electrode TE2. The second inorganic film TCF2 may be disposed between the first reflective electrode RE1 and the first transparent electrode TE1.

The second inorganic film TCF2 might not be disposed between the second reflective electrode RE2 and the second transparent electrode TE2, and might not be disposed between the third reflective electrode RE3 and the third transparent electrode TE3.

However, embodiments of the present inventive concept are not necessarily limited thereto, and replacing the first inorganic film TCF1, the second inorganic film TCF2 may be disposed between the second reflective electrode RE2 and the second transparent electrode TE2, and embodiments of the present inventive concept are not necessarily limited to any one embodiment.

Between the first reflective electrode RE1 and the first transparent electrode TE1, both the first inorganic film TCF1 and the second inorganic film TCF2 may be disposed, and thus the first reflective electrode RE1 and the first transparent electrode TE1 may be spaced apart by a first distance in the third direction DR3, which is a thickness direction of the display panel DP. Between the second reflective electrode RE2 and the second transparent electrode TE2, the first inorganic film TCF1 may be disposed, and thus the second reflective electrode RE2 and the second transparent electrode TE2 may be spaced apart by a second distance in the third direction DR3, which is a thickness direction of the display panel DP. The first distance may be greater than the second distance. Between the third reflective electrode RE3 and the third transparent electrode TE3, the separation layer TCF might not be disposed, and thus the third transparent electrode TE3 may be directly disposed on the third reflective electrode RE3.

The second inorganic film TCF2 might not be disposed between both the second reflective electrode RE2 and the second transparent electrode TE2, and the third reflective electrode RE3 and the third transparent electrode TE3, and may be spaced apart from both the second reflective electrode RE2 and the third reflective electrode RE3.

In FIG. 4, side surfaces of the first inorganic film TCF1 and the second inorganic film TCF2 are aligned with a side surface of the first reflective electrode RE1, but embodiments of the present inventive concept are not necessarily limited thereto, and the side surfaces of the first inorganic film TCF1 and the second inorganic film TCF2 may extend to the non-light emitting region NPXA, and embodiments of the present inventive concept are not necessarily limited to any one embodiment.

Each of the first inorganic film TCF1 and the second inorganic film TCF2 includes an inorganic material. Each of the first inorganic film TCF1 and the second inorganic film TCF2 may include at least one of silicon oxide (SiOₓ), silicon nitride (SiNₓ), or silicon oxynitride (SiOₓN_{y}). Each of the first inorganic film TCF1 and the second inorganic film TCF2 may include, for example, silicon oxide (SiOₓ).

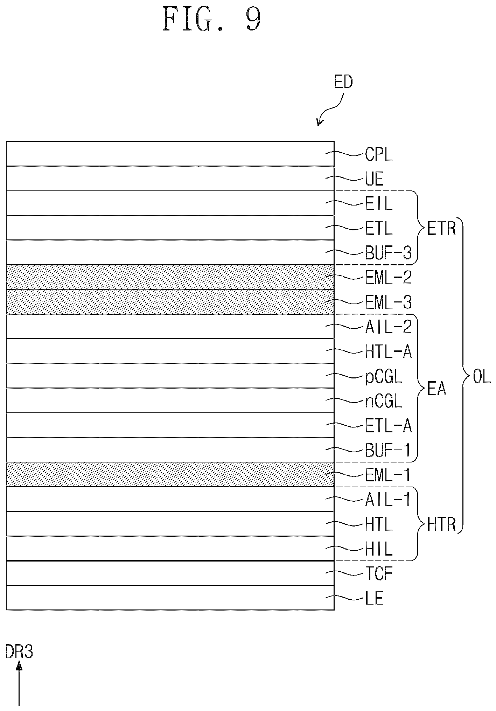

According to an embodiment, the transparent electrodes TE1, TE2, and TE3 may be in contact with the reflective electrodes RE1, RE2, and RE3. The transparent electrodes TE1, TE2, and TE3 may be in contact with the reflective electrodes RE1, RE2, and RE3 to provide charges to a hole transport region HTR (see FIG. 9) disposed on the transparent electrodes TE1, TE2, and TE3.

According to an embodiment of the present inventive concept, the first inorganic film TCF1 and the second inorganic film TCF2 are disposed between the first reflective electrode RE1 and the first transparent electrode TE1, and thus the first transparent electrode TE1 may be in contact with the first reflective electrode RE1 through the first contact hole CN1 passing through the first inorganic film TCF1 and the second inorganic film TCF2.

According to an embodiment of the present inventive concept, the first contact hole CN1 may be defined inside the first light emitting region PXA-1. The first contact hole CN1 may pass through the first inorganic film TCF1 and the second inorganic film TCF2 to expose a portion of the first reflective electrode RE1. The first transparent electrode TE1 may be disposed in the first contact hole CN1 and may thus come into contact with the first reflective electrode RE1.

Since the first inorganic film TCF1 and the second inorganic film TCF2 are removed in a region where the first contact hole CN1 is defined, when resonance is induced in a region overlapping the first contact hole CN1, a resonance frequency different from an optimal resonance frequency of the first light emitting element ED-1 may be formed. Therefore, to prevent this, a first pattern P-C1 may be disposed on the first transparent electrode TE1 overlapping the first contact hole CN1.

According to an embodiment of the present inventive concept, the first contact hole CN1 and the first pattern P-C1 may have a rectangle shape in a cross-section. In addition, an upper surface of the first pattern P-C1 may be coplanar with an upper surface of the first transparent electrode TE1, which does not overlap the first contact hole CN1.

According to an embodiment of the present inventive concept, the first light emitting region PXA-1 may be defined as a first region A1 and a second region A2 surrounded by the first region A1. The second region A2 may be defined as a region that overlaps the first contact hole CN1. The first region A1 may be a region in which an optimal resonance frequency of the first light emitting element ED-1 is formed, and the second region A2 may be defined as a region in which a frequency different from the optimal resonance frequency is formed. The first pattern P-C1 may be disposed in the second region A2. Accordingly, light might not be generated in the second region A2.

According to an embodiment of the present inventive concept, a separate non-light emitting region NPXA for bringing the first reflective electrode RE1 into contact with the first transparent electrode TE1 may be reduced by putting the first reflective electrode RE1 into contact with the first transparent electrode TE1 within the first light emitting region PXA-1. Consequently, an aperture ratio of the first light emitting region PXA-1 may be secured.

According to an embodiment of the present inventive concept, the second contact hole CN2 may be defined inside the second light emitting region PXA-2. The second contact hole CN2 may pass through the first inorganic film TCF1 to expose a portion of the second reflective electrode RE2. The second transparent electrode TE2 may contact the second reflective electrode RE2 at the second contact hole CN2.

Since the first inorganic film TCF1 is removed in a region where the second contact hole CN2 is defined, when resonance is induced in a region overlapping the second contact hole CN2, a resonance frequency different from an optimal resonance frequency of the second light emitting element ED-2 may be formed. Therefore, to prevent this, a second pattern P-C2 may be disposed on the second transparent electrode TE2 overlapping the second contact hole CN2. According to an embodiment of the present inventive concept, the second contact hole CN2 and the second pattern P-C2 may have a rectangle shape in a cross-section. In addition, an upper surface of the second pattern P-C2 may be coplanar with an upper surface of the second transparent electrode TE2, which does not overlap the second contact hole CN2.

The first pattern P-C1 and the second pattern P-C2 may include the same material as the pixel defining film PDL. The first pattern P-C1 and the second pattern P-C2 may include an inorganic material or an organic material.

According to an embodiment of the present inventive concept, the second light emitting region PXA-2 may be defined as the first region A1 and the second region A2 surrounded by the first region A1. The second region A2 may be defined as a region that overlaps the second contact hole CN2. The first region A1 may be a region in which an optimal resonance frequency of the second light emitting element ED-2 is formed, and the second region A2 may be defined as a region in which a frequency different from the optimal resonance frequency is formed. The second pattern P-C2 may be disposed in the second region A2. Accordingly, light might not be generated in the second region A2.

According to an embodiment of the present inventive concept, a separate non-light emitting region NPXA for bringing the second reflective electrode RE2 into contact with the second transparent electrode TE2 may be reduced by putting the second reflective electrode RE2 into contact with the second transparent electrode TE2 within the second light emitting region PXA-2. Consequently, an aperture ratio of the second light emitting region PXA-2 may be secured.

According to an embodiment of the present inventive concept, a depth of the first contact hole CN1 may be greater than a depth of the second contact hole CN2. A width of the first contact hole CN1 may be equal to or greater than a width of the second contact hole CN2.

Between the third reflective electrode RE3 and the third transparent electrode TE3, the separation layer TCF might not be disposed, and thus the third reflective electrode RE3 may be in direct contact with the third transparent electrode TE3.

As described in FIGS. 3A to 3C, the first contact hole CN1 may be defined inside the first light emitting region PXA-1, and the second contact hole CN2 may be defined inside the second light emitting region PXA-2. A contact hole might not be defined inside the third light emitting region PXA-3.

The display element layer DP-ED of the display panel DP may include the pixel defining film PDL. The pixel defining film PDL may be disposed on at least a portion of the lower electrodes LE1, LE2, and LE3. The pixel defining film PDL may cover a portion of upper surfaces and side surfaces of the transparent electrodes TE1, TE2, and TE3, a side surface of the separation layer TCF, and a side surface of the reflective electrodes RE1, RE2, and RE3.

The pixel defining film PDL may include a pixel opening that exposes at least a portion of the upper surfaces of the transparent electrodes TE1, TE2, and TE3 included in the lower electrodes LE1, LE2, and LE3, and the pixel opening may define the first to third light emitting regions PXA-1, PXA-2, and PXA-3.

The pixel defining film PDL may include an inorganic material. The pixel defining film PDL may include at least one of silicon oxide (SiOₓ), silicon nitride (SiNₓ), or silicon oxynitride (SiOₓN_{y}). The pixel defining film PDL may include, for example, silicon oxide (SiOₓ). The pixel defining film PDL according to an embodiment may include an organic material.

A side surface of the pixel defining film PDL defining a pixel opening may have a predetermined taper angle. The side surface of the pixel defining film PDL may have a taper angle of about 40° or greater. The side surface of the pixel defining film PDL may have a taper angle of, for example, about 75° to about 90°. The pixel defining film PDL includes an inorganic material, and thus the side surface of the pixel defining film PDL may have a high taper angle of about 75° or greater.

Each of the first inorganic layer TCF1 and the second inorganic layer TCF2 may have a thickness of, for example, about 100 angstroms (Å) to about 3000 angstroms (Å). The pixel defining film PDL may may have a thickness of, for example, about 500 angstroms (Å) to about 3000 angstroms (Å).

In the first to third light emitting elements ED-1, ED-2, and ED-3, the organic layer OL may be provided as a common layer. The organic layer OL may include at least one emission layer. The first to third light emitting elements ED-1, ED-2, and ED-3 may be light emitting elements having a tandem structure.

The organic layer OL may overlap the first to third light emitting regions PXA-1, PXA-2, and PXA-3 and the non-light emitting region NPXA. In this specification, the wording, "one component and another component overlapping each other" is not necessarily limited to the element and the other element having the same planar shape and the same planar area, and also means the cases of having different areas and/or different shapes. The organic layer OL may include at least a plurality of emission layers EML-1, EML-2, and EML-3 (see FIG. 9).

Referring to FIG. 9, the organic layer OL, according to an embodiment, may include a hole transport region HTR, a first emission layer EML-1, a light emitting auxiliary portion EA, a second emission layer EML-2, a third emission layer EML-3, and an electron transport region ETR. In a light emitting element ED, the hole transport region HTR, the first emission layer EML-1, the light emitting auxiliary region EA, the second emission layer EML-2, the third emission layer EML-3, and the electron transport region ETR may be provided as a common layer.

The light emitting element ED including the first emission layer EML-1, the second emission layer EML-2, and the third emission layer EML-3 that generate light in different wavelength ranges may emit white light. In an embodiment, the hole transport region HTR, the light emitting auxiliary portion EA, and the electron transport region ETR which are included in the light emitting element ED may be provided to have respective thicknesses to induce nth-order resonance for red light, green light, or blue light. The inorganic film TCF (see FIG. 4) may also be provided to induce nth-order resonance for red light, green light, or blue light emitted from each of the emission layers EML-1, EML-2, and EML-3 of the light emitting element ED.

The first to third emission layers EML-1, EML-2, and EML-3 provided as a common layer may be subjected to deposition without a mask, and thus pixels having a smaller area may be formed. The display panel DP according to an embodiment may have many pixels having a smaller area disposed on a plane, and may thus achieve high resolution. In the light emitting element ED, the hole transport region HTR may be provided on a lower electrode LE and a separation layer TCF. The lower electrode LE may correspond to the lower electrodes LE1, LE2, and LE3.

The hole transport region HTR may have a single layer formed of a single material, a single layer formed of a plurality of different materials, or a multilayer structure having a plurality of layers formed of a plurality of different materials.

The hole transport region HTR may include a hole injection layer HIL, a first hole transport layer HTL, and a first sub-hole control layer AIL-1, which are sequentially stacked. Unlike what is shown, at least one of the hole injection layer HIL, the first hole transport layer HTL, or the first sub-hole control layer AIL-1 might not be provided.

The first sub-hole control layer AIL-1 may be disposed adjacent to the first emission layer EML-1 that generates first light. The first sub-hole control layer AIL-1 may be formed to have a highest occupied molecular orbital (HOMO) energy level and a lowest unoccupied molecular orbital (LUMO) energy level in which holes may readily move. Accordingly, an increase in the driving voltage of the light emitting element ED including the first sub-hole control layer AIL-1 may be prevented. In addition, the first sub-hole control layer AIL-1 may block electrons moving from the first emission layer EML-1 to the hole transport region HTR. Therefore, the display panel DP including the light emitting element ED including the first sub-hole control layer AIL-1 may have a longer display lifespan.

The electron transport region ETR may be provided on the light emitting auxiliary portion EA. The electron transport region ETR may have a single layer formed of a single material, a single layer formed of a plurality of different materials, or a multilayer structure having a plurality of layers formed of a plurality of different materials. For example, the electron transport region ETR may include an anthracene-based compound.

The electron transport region ETR may include a third buffer layer BUF-3, a first electron transport layer ETL, and an electron injection layer EIL which are sequentially stacked. At least one of the third buffer layer BUF-3, the first electron transport layer ETL, or the electron injection layer EIL might be omitted. The second buffer layer BUF-2, the first electron transport layer ETL, and the electron injection layer EIL may include the above-described compounds of the electron transport region ETR. The second buffer layer BUF-2 may block holes moving from the third emission layer EML-3 to the electron transport region ETR.

The light emitting auxiliary portion EA disposed between the first emission layer EML-1 and the second emission layer EML-2 may include a first buffer layer BUF-1, a second electron transport layer ETL-A, a first charge generation layer nCGL, a second charge generation layer pCGL, and a second hole transport layer HTL-A, and a second sub-hole control layer AIL-2 which are sequentially stacked. The first charge generation layer nCGL may be an n-type charge generation layer, and the second charge generation layer pCGL may be a p-type charge generation layer. Unlike what is shown, at least one of the first buffer layer BUF-1, the second electron transport layer ETL-A, the first charge generation layer nCGL, the second charge generation layer pCGL, the second hole transport layer HTL-A, or the second sub-hole control layer AIL-2 might not be provided.

The second sub-hole control layer AIL-2 may include a material different from that of the above-described first sub-hole control layer AIL-1. The second sub-hole control layer AIL-2 may include a material that helps the second emission layer EML-2 generate second light or a material that helps the third emission layer EML-3 generate third light. The first sub-hole control layer AIL-1 may include a material that helps the first emission layer EML-1 generate the first light. However, embodiments of the present inventive concept are not necessarily limited thereto, and the first sub-hole control layer AIL-1 and the second sub-hole control layer AIL-2 may include the same material.

The second sub-hole control layer AIL-2 may be disposed adjacent to the third emission layer EML-3 that generates the third light or the second emission layer EML-2 that generates the second light. The second sub-hole control layer AIL-2 may be formed to have a highest occupied molecular orbital (HOMO) energy level and a lowest unoccupied molecular orbital (LUMO) energy level in which holes may readily move. Accordingly, an increase in the driving voltage of the light-emitting element ED including the second sub-hole control layer AIL-2 may be prevented. In addition, the second sub-hole control layer AIL-2 may block electrons moving from the second emission layer EML-2 or the third emission layer EML-3 to the second hole transport layer HTL-A. Therefore, the display panel DP including the light emitting element ED including the second sub-hole control layer AIL-2 may have a longer display lifespan.

An upper electrode UE may be provided on the organic layer OL. The upper electrode UE may correspond to the upper electrode UE described above in FIG. 4. The upper electrode UE may include at least one selected from Ag, Mg, Cu, Al, Pt, Pd, Au, Ni, Nd, Ir, Cr, Li, Ca, LiF, Mo, Ti, W, In, Sn, and Zn, two or more compounds selected therefrom, two or more mixtures selected therefrom, or an oxide thereof.

The upper electrode UE may be a transmissive electrode, a transflective electrode, or a reflective electrode. When the upper electrode UE is a transmissive electrode, the upper electrode UE may be formed of a transparent metal oxide, for example, indium tin oxide (ITO), indium zinc oxide (IZO), zinc oxide (ZnO), indium tin zinc oxide (ITZO), and the like.

When the upper electrode UE is a transflective electrode or a reflective electrode, the upper electrode UE may include Ag, Mg, Cu, Al, Pt, Pd, Au, Ni, Nd, Ir, Cr, Li, Ca, LiF/Ca, LiF/Al, Mo, Ti, Yb, W, a compound thereof, or a mixture thereof (e.g., AgMg, AgYb, or MgYb). Alternatively, the upper electrode UE may have a multilayer structure including a reflective film or a transflective film formed of the above-described materials, and a transparent conductive film formed of indium tin oxide (ITO), indium zinc oxide (IZO), zinc oxide (ZnO), indium tin zinc oxide (ITZO), and the like. For example, the upper electrode UE may include the above-described metal materials, a combination of two or more metal materials selected from the above-described metal materials, or oxides of the above-described metal materials.

A capping layer CPL may be provided on the upper electrode UE. The capping layer CPL may include a multilayer or a single layer. The capping layer CPL may be an organic layer or an inorganic layer.

In an embodiment, the first emission layer EML-1 may be disposed on the hole transport region HTR. The second emission layer EML-2 may be disposed on the light emitting auxiliary portion EA. The third emission layer EML-3 may be disposed between the second emission layer EML-2 and the light emitting auxiliary portion EA.

According to an embodiment, the first emission layer EML-1 may be disposed on the hole transport region HTR, the second emission layer EML-2 may be disposed on the light emitting auxiliary portion EA, and the third emission layer EML-3 may be disposed between the first emission layer EML-1 and the light emitting auxiliary portion EA. However, this is only presented as an example, and embodiments of the present inventive concept are not necessarily limited thereto.

Referring back to FIG. 4, in the first to third light emitting elements ED-1, ED-2, and ED-3, the upper electrode UE may be provided as a common electrode. The upper electrode UE may be a common layer overlapping both the first to third light emitting regions PXA-1, PXA-2, and PXA-3 and the non-light emitting region NPXA and having the form of a single body. In this specification, the upper electrode UE disposed on the organic layer OL may indicate "cathode."

The capping layer CPL may be disposed on the upper electrode UE. The capping layer CPL may include a multilayer or a single layer. The capping layer CPL may be an organic layer or an inorganic layer. For example, when the capping layer CPL includes an inorganic material, the inorganic material may include an alkali metal compound such as LiF, an alkaline earth metal compound such as MgF₂, SiON, SiNx, SiO_{y}, and the like.

The encapsulation layer TFE may be disposed on the display element layer DP-ED. The encapsulation layer TFE may protect the light emitting element layer DP-ED from moisture, oxygen, and foreign substances such as dust particles. The encapsulation layer TFE may include at least one inorganic film (hereinafter, an encapsulation inorganic film). In addition, the encapsulation layer TFE may include at least one organic film (hereinafter, an encapsulation organic film) and at least one encapsulation inorganic film.

The encapsulation inorganic film may protect the display element layer DP-ED from moisture/oxygen, and the encapsulation organic film may protect the display element layer DP-ED from foreign substances such as dust particles. The encapsulation inorganic film may include silicon nitride, silicon oxy nitride, silicon oxide, titanium oxide, aluminum oxide, and the like, but is not necessarily particularly limited thereto. The encapsulation organic film may include an acrylic compound, an epoxy-based compound, and the like. The encapsulation organic film may include a photopolymerizable organic material, and is not necessarily particularly limited.

A color filter layer CFL may be disposed on the encapsulation layer TFE. The color filter layer CFL may include a first color filter CF1 corresponding to the first light emitting region PXA-1, a second color filter CF2 corresponding to the second light emitting region PXA-2, and a third color filter CF3 corresponding to the third light emitting region PXA-3. The color filter layer CFL may further include a light blocking portion. The light blocking portion may be a black matrix. The light blocking portion may be formed including an organic light blocking material or an inorganic light blocking material, both including a black pigment or a black dye. The light blocking portion may prevent light leakage, and separate boundaries between the adjacent color filters CF1, CF2, and CF3.

Each of the first to third color filters CF1, CF2, and CF3 may include a polymer photosensitive resin and a colorant. In this specification, the colorant includes a pigment and a dye. A red colorant includes a red pigment and a red dye, a green colorant includes a green pigment and a green dye, and a blue colorant includes a blue pigment and a blue dye.

In FIG. 4, the first color filter CF1 may include a red pigment or a red dye, the second filter CF2 may include a green pigment or a green dye, and the third filter CF3 may include a blue pigment or a blue dye. For example, the first color filter CF1 disposed on the first light emitting element ED-1 may include a red color colorant, the second color filter disposed on the second light emitting element ED-2 may include a green color colorant, and the third color filter disposed on the third light emitting element ED-3 may include a blue color colorant.

An overcoat layer OC may be disposed on the color filter layer CFL. The overcoat layer OC may cover a step formed by the components disposed below the overcoat layer OC. The overcoat layer OC may be a rigid substrate, or a flexible substrate that is bendable, foldable, rollable, to at least a noticeable extent without cracking or otherwise sustaining damage, or the like.

The overcoat layer OC may be a glass substrate, a metal substrate, or a polymer substrate. However, embodiments of the present inventive concept are not necessarily limited thereto, and the overcoat layer OC may be an inorganic layer, an organic layer, or a composite material layer.

The display panel DP, according to an embodiment of the present inventive concept, includes an inorganic film disposed between a reflective electrode and a transparent electrode in at least one lower electrode to induce a resonance structure suitable for a wavelength emitted from the light emitting element, thereby achieving superior display resolution and improved luminous efficiency.

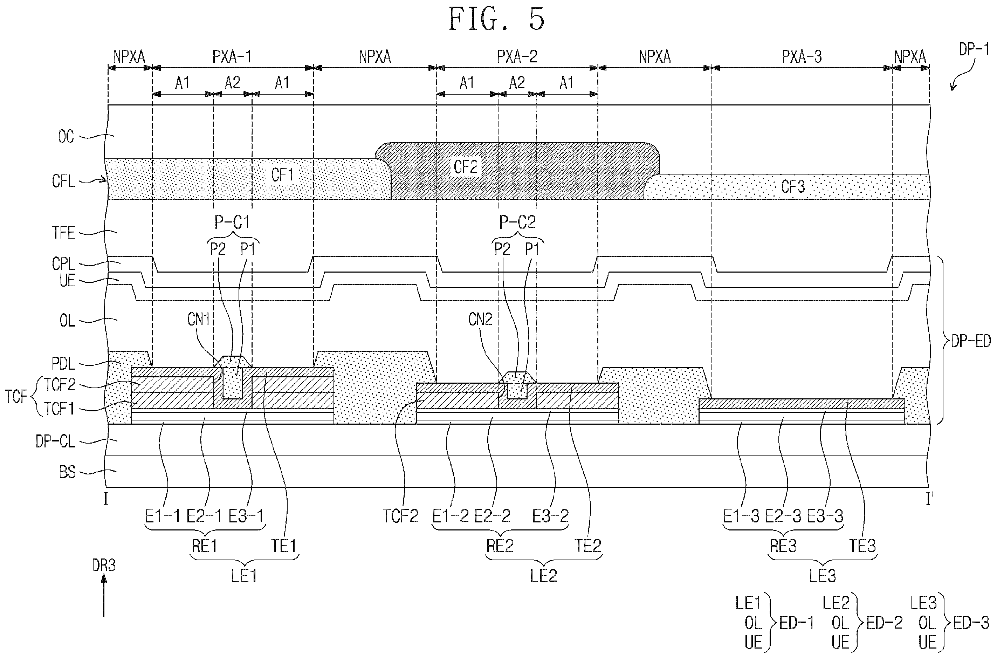

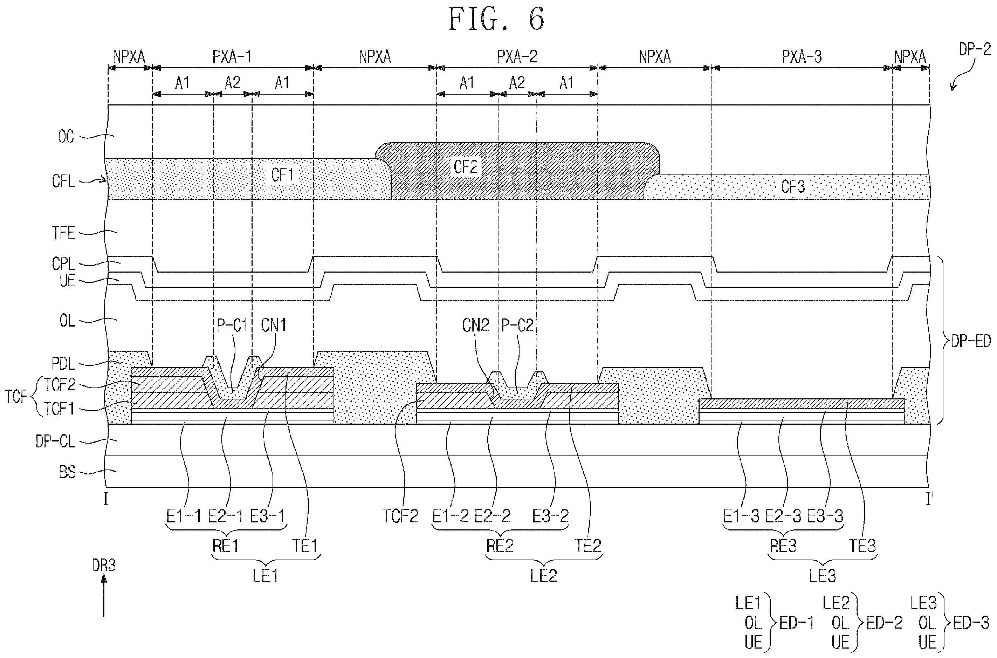

FIG. 5 is a cross-sectional view of a display panel according to an embodiment of the present inventive concept. FIG. 6 is a cross-sectional view of a display panel according to an embodiment of the present inventive concept. The same/similar reference numerals are used for the same/similar components as those described in FIG. 4, and to the extent that an element is not described in detail with respect to this figure, it may be understood that the element is at least similar to a corresponding element that has been described elsewhere within the present disclosure.

Referring to FIG. 5, a display panel DP-1 may include a base layer BL, a circuit layer DP-CL, a display element layer DP-ED, and an encapsulation layer TFE. In addition, the display panel DP may further include a color filter layer CFL disposed on the encapsulation layer TFE. The display element layer DP-ED may include a separation layer TCF. The separation layer TCF may include a first inorganic film TCF1 and a second inorganic film TCF2.

According to an embodiment of the present inventive concept, the first contact hole CN1 may be defined inside the first light emitting region PXA-1. The first contact hole CN1 may pass through the first inorganic film TCF1 and the second inorganic film TCF2 to expose a portion of the first reflective electrode RE1. The first transparent electrode TE1 may be disposed in the first contact hole CN1 and may thus come into contact with the first reflective electrode RE1.

A first pattern P-C1 may be disposed on the first transparent electrode TE1 overlapping the first contact hole CN1.

The second contact hole CN2 may be defined within the second light emitting region PXA-2. The second contact hole CN2 may pass through the second inorganic film TCF2 to expose a portion of the second reflective electrode RE2. The second transparent electrode TE2 may contact the second reflective electrode RE2 at the second contact hole CN2.

A second pattern P-C2 may be disposed on the second transparent electrode TE2 overlapping the second contact hole CN2.

According to the present embodiment, each of the first pattern P-C1 and the second pattern P-C2 may include a first portion P1 and a second portion P2.

The first portion P1 is a portion disposed inside the first and second contact holes CN1 and CN2, and the second portion P2 may be a portion disposed on the first portion P1 and protruding from upper surfaces of the first and second transparent electrodes TE1 and TE2.

The first pattern P-C1 and the second pattern P-C2 may include the same material as the pixel defining film PDL. The first pattern P-C1 and the second pattern P-C2 may include an organic material.

According to an embodiment of the present inventive concept, the first and second contact holes CN1 and CN2 may have a square shape in a cross-section. Accordingly, the first pattern P1 may have a square shape in a cross-section.

Referring to FIG. 6, a display panel DP-2 may include a base layer BL, a circuit layer DP-CL, a display element layer DP-ED, and an encapsulation layer TFE. In addition, the display panel DP may further include a color filter layer CFL disposed on the encapsulation layer TFE. The display element layer DP-ED may include a separation layer TCF. The separation layer TCF may include a first inorganic film TCF1 and a second inorganic film TCF2.

According to an embodiment of the present inventive concept, the first contact hole CN1 may be defined inside the first light emitting region PXA-1. The first contact hole CN1 may pass through the first inorganic film TCF1 and the second inorganic film TCF2 to expose a portion of the first reflective electrode RE1. The first transparent electrode TE1 may be disposed in the first contact hole CN1 and may thus come into contact with the first reflective electrode RE1.

In this embodiment, a side surface of the first inorganic film TCF1 defining the first contact hole CN1 and a side surface of the second inorganic film TCF2 may be aligned with each other and may be inclined at a predetermined angle from the first reflective electrode RE1.

A first pattern P-C1 may be disposed on the first transparent electrode TE1 overlapping the first contact hole CN1. The first pattern P-C1 may be overlapping with a side surface of the first inorganic film TCF1 defining the first contact hole CN1, a side surface of the second inorganic film TCF2, and a portion of an upper surface of the second inorganic film TCF2.

The second contact hole CN2 may be defined within the second light emitting region PXA-2. The second contact hole CN2 may pass through the second inorganic film TCF2 to expose a portion of the second reflective electrode RE2. The second transparent electrode TE2 may contact the second reflective electrode RE2 at the second contact hole CN2.

In this embodiment, the side surfaces of the second inorganic film TCF2 defining the second contact hole CN2 may be aligned with each other and may be inclined at a predetermined angle from the second reflective electrode RE2.

A second pattern P-C2 may be disposed on the second transparent electrode TE2 overlapping the second contact hole CN2. The second pattern P-C2 may be in contact with the side surface of the second inorganic film TCF2 defining the second contact hole CN2 and a portion of the upper surface of the second inorganic film TCF2.

The first pattern P-C1 and the second pattern P-C2 may include the same material as the pixel defining film PDL. In the present embodiment, the first pattern P-C1 and the second pattern P-C2 may include an inorganic material.

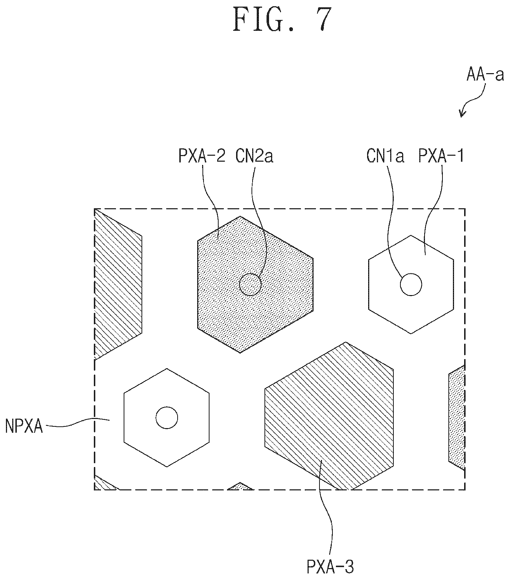

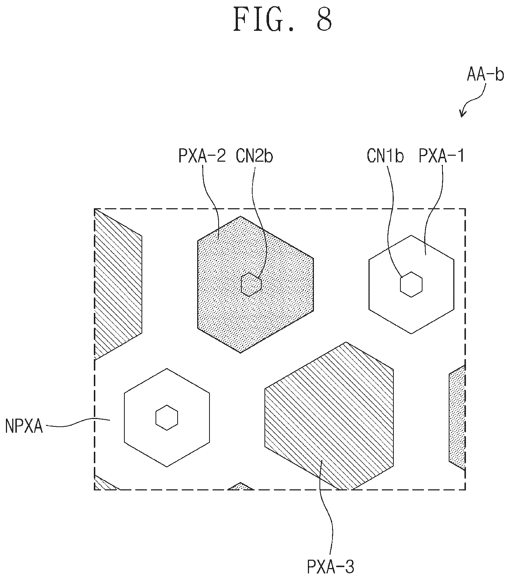

FIG. 7 is a plan view of a display panel according to an embodiment of the present inventive concept. FIG. 8 is a plan view of a display panel according to an embodiment of the present inventive concept. FIGS. 7 and 8 show some regions of the first to third light emitting regions PXA-1, PXA-2, and PXA-3 described in FIG. 3B. The same/similar reference numerals are used for the same/similar components as/to the components described in FIGS. 3B to 4, and to the extent that an element is not described in detail with respect to this figure, it may be understood that the element is at least similar to a corresponding element that has been described elsewhere within the present disclosure.

Referring to FIG. 7, an active region AA-a, a light emitting region PXA, and a non-light emitting region NPXA of the display panel DP (see FIG. 4) may be included. The non-light emitting region NPXA may surround the light emitting region PXA. The light emitting region PXA may be provided in plural. The light emitting regions PXA may each include a first light emitting region PXA-1, a second light emitting region PXA-2, and a third light emitting region PXA-3.

According to an embodiment of the present inventive concept, each of the first to third light emitting regions PXA-1, PXA-2, and PXA-3 may have different shapes. For example, the first light emitting region PXA-1 may have a hexagonal. Each of the second and third light emitting regions PXA-2 and PXA-3 may have a hexagonal shape.

According to an embodiment of the present inventive concept, among the first to third light emitting regions PXA-1, PXA-2, and PXA-3, contact holes CN1a and CN2a may be defined in the first and second light emitting regions PXA-1 and PXA-2. For example, the first contact hole CN1a may be defined in the first light emitting region PXA-1, and the second contact hole CN2a may be defined in the second light emitting region PXA-2.

According to an embodiment of the present inventive concept, the shape of each of the contact holes CN1a and CN2a on a plane (e.g., the planar shape) may be different from the shape of the first to third light emitting regions PXA-1, PXA-2, and PXA-3 on a plane (e.g., the planar shape). For example, the contact holes CN1a and CN2a may be circular on a plane (e.g., the planar shape).

Referring to FIG. 8, an active region AA-b, a light emitting region PXA, and a non-light emitting region NPXA of the display panel DP (see FIG. 4) may be included. The non-light emitting region NPXA may surround the light emitting region PXA. The light emitting region PXA may be provided in plural. The light emitting regions PXA may each include a first light emitting region PXA-1, a second light emitting region PXA-2, and a third light emitting region PXA-3.

According to an embodiment of the present inventive concept, each of the first to third light emitting regions PXA-1, PXA-2, and PXA-3 may have different shapes. For example, the first light emitting region PXA-1 may have a hexagonal. Each of the second and third light emitting regions PXA-2 and PXA-3 may have a hexagonal shape.

According to an embodiment of the present inventive concept, among the first to third light emitting regions PXA-1, PXA-2, and PXA-3, contact holes CN1b and CN2b may be defined in the first and second light emitting regions PXA-1 and PXA-2. For example, the first contact hole CN1b may be defined in the first light emitting region PXA-1, and the second contact hole CN2b may be defined in the second light emitting region PXA-2.

According to an embodiment of the present inventive concept, the shape of each of the contact holes CN1b and CN2b on a plane (e.g., the planar shape) may be the same as the shape of the first to third light emitting regions PXA-1, PXA-2, and PXA-3 on a plane (e.g., the planar shape). For example, the first contact hole CN1b may have an octagonal shape on a plane (e.g., the planar shape), and the second contact hole CN2b may have a hexagonal shape on a plane (e.g., the planar shape).

As discussed embodiments can provide a display device, comprising: a base layer including a first light emitting region, a second light emitting region, a third light emitting region, and a non-light emitting region; a lower electrode including a first reflective electrode overlapping the first light emitting region, a second reflective electrode overlapping the second light emitting region, a third reflective electrode overlapping the third light emitting region, a first transparent electrode disposed on the first reflective electrode, a second transparent electrode disposed on the second reflective electrode, and a third transparent electrode disposed on the third reflective electrode; an organic layer disposed on the lower electrode and including an emission layer; an upper electrode disposed on the organic layer; and a separation layer disposed between the first reflective electrode and the first transparent electrode and between the second reflective electrode and the second transparent electrode.

In some embodiments, a first contact hole is defined in the separation layer overlapping the first light emitting region and a second contact hole is defined in the separation layer overlapping the second light emitting region, and wherein the first transparent electrode is disposed in the first contact hole and is connected to the first reflective electrode, and the second transparent electrode is disposed in the second contact hole and is connected to the second reflective electrode.

The separation layer may comprise a first inorganic layer and a second inorganic layer, each including an inorganic material.

The first inorganic layer and the second inorganic layer may be disposed between the first reflective electrode and the first transparent electrode. The first inorganic layer, and not the second inorganic layer, may be disposed between the second reflective electrode and the second transparent electrode.

Embodiments can provide an electronic device comprising the display device of any of the above mentioned embodiments.

A display panel of an embodiment of the present inventive concept may achieve high resolution and high luminous efficiency through excellent optical resonance design.

In addition, an electronic device including a display panel in which unnecessary non-light emitting regions are reduced and an aperture ratio of light emitting regions is secured may be provided by bringing a reflective electrode into contact with a transparent electrode within the light emitting regions.

In the above, description has been made with reference to embodiments of the present inventive concept, but those skilled or of ordinary skill in the art may understand that various modifications and changes may be made to the present inventive concept insofar as such modifications and changes do not depart from the technical scope of the present inventive concept.

## Claims

1. A display device, comprising:
a base layer including a first light emitting region, a second light emitting region, a third light emitting region, and a non-light emitting region;
a lower electrode including a first reflective electrode overlapping the first light emitting region, a second reflective electrode overlapping the second light emitting region, a third reflective electrode overlapping the third light emitting region, a first transparent electrode disposed on the first reflective electrode, a second transparent electrode disposed on the second reflective electrode, and a third transparent electrode disposed on the third reflective electrode;
an organic layer disposed on the lower electrode and including an emission layer;
an upper electrode disposed on the organic layer; and
a separation layer disposed between the first reflective electrode and the first transparent electrode and between the second reflective electrode and the second transparent electrode.

2. The display device of claim 1, wherein a first contact hole is defined in the separation layer overlapping the first light emitting region and a second contact hole is defined in the separation layer overlapping the second light emitting region, and
wherein the first transparent electrode is disposed in the first contact hole and is connected to the first reflective electrode, and the second transparent electrode is disposed in the second contact hole and is connected to the second reflective electrode.

3. The display device of claim 1 or 2, wherein the separation layer comprises a first inorganic layer and a second inorganic layer, each including an inorganic material.

4. The display device of claim 2, wherein the first inorganic layer and the second inorganic layer are disposed between the first reflective electrode and the first transparent electrode, and
wherein the first inorganic layer is disposed without the second inorganic layer between the second reflective electrode and the second transparent electrode.

5. The display device of claim 4, wherein a first distance from the first reflective electrode to the first transparent electrode is greater than a second distance from the second reflective electrode to the second transparent electrode.

6. The display device of claim 4 or 5, wherein the first inorganic layer and the second inorganic layer each include at least one of silicon oxide, SiOₓ, silicon nitride, SiNₓ, or silicon oxynitride, SiOₓN_{y}.

7. The display device of any one of claims 2 to 6, further comprising a first pattern disposed on the first transparent electrode overlapping the first contact hole and a second pattern disposed on the second transparent electrode overlapping the second contact hole.

8. The display device of claim 7, further comprising a pixel defining film disposed on the base layer and having pixel openings, exposing at least a portion of each of the first transparent electrode, the second transparent electrode, and the third transparent electrode;
optionally wherein the first pattern and the second pattern comprise a same material as the pixel defining film;
optionally wherein the pixel defining film, the first pattern, and the second pattern each comprise either an organic material or an inorganic material.

9. The display device of claim 7 or 8, wherein: an upper surface of the first pattern is coplanar with an upper surface of the first transparent electrode, which does not overlap the first contact hole; and an upper surface of the second pattern is coplanar with an upper surface of the second transparent electrode, which does not overlap the second contact hole; and/or
wherein the first pattern and the second pattern each comprise a first portion disposed inside a corresponding contact hole and a second portion disposed on the first portion and protruding from a corresponding transparent electrode; and/or
wherein a side surface of the separation layer defining the first contact hole is inclined at a first predetermined angle from the first reflective electrode, and wherein a side surface of the separation layer defining the second contact hole is inclined at a second predetermined angle from the second reflective electrode.

10. The display device of any one of claims 1 to 9, wherein the third reflective electrode and the third transparent electrode are in direct contact with one another; and/or
wherein the first reflective electrode, the second reflective electrode, and the third reflective electrode each comprise: a first layer including a transparent conductive oxide; a second layer disposed on the first layer and including a reflective metal material; and a third layer disposed on the second layer and including a transparent conductive oxide.

11. The display device of any one of claims 1 to 10, further comprising:
an encapsulation layer disposed on the upper electrode;
a color filter layer disposed on the encapsulation layer, the color filter layer including a first color filter overlapping the first light emitting region, a second color filter overlapping the second light emitting region, and a third color filter overlapping the third light emitting region; and
an overcoat layer disposed on the color filter layer.

12. The display device of any one of claims 1 to **11,** wherein the first, second, and third light emitting regions each have different planar shapes and areas.

13. The display device of any one of claims 1 to 12, wherein the first light emitting region has a different planar shape than the first contact hole and the second light emitting region has a different planar shape than the second contact hole; or
wherein the first light emitting region has a same planar shape as the first contact hole, and the second light emitting region has a same planar shape as the second contact hole.

14. The display device of any one of claims 1 to 13, wherein the first to third reflective electrodes are spaced apart from one another and all disposed within a same layer.

15. An electronic device comprising the display device of any one of claims 1 to 14.
